(19) Europäisches Patentamt
European Patent Office
Office européen des brevets

(11) Veröffentlichungsnummer : **0 463 486 B1**

(12) # EUROPÄISCHE PATENTSCHRIFT

(45) Veröffentlichungstag der Patentschrift : **11.10.95 Patentblatt 95/41**

(51) Int. Cl.[6] : **G03F 7/32**

(21) Anmeldenummer : **91109676.6**

(22) Anmeldetag : **13.06.91**

(54) **Verfahren zur Herstellung photopolymerer flexographischer Reliefdruckplatten.**

(30) Priorität : **27.06.90 DE 4020373**

(43) Veröffentlichungstag der Anmeldung : **02.01.92 Patentblatt 92/01**

(45) Bekanntmachung des Hinweises auf die Patenterteilung : **11.10.95 Patentblatt 95/41**

(84) Benannte Vertragsstaaten : **BE CH DE FR GB IT LI NL SE**

(56) Entgegenhaltungen :
**EP-A- 0 332 070**
**FR-A- 2 526 178**

(56) Entgegenhaltungen :
**WORLD PATENTS INDEX LATEST, Derwent Publications Ltd., London, GB; AN 83-37627K & JP-A-58 040 458**
**PATENT ABSTRACTS OF JAPAN, vol. 10, no. 354 (P-521)(2410) 28. November 1986 & JP-A-61 153 634**
**PATENT ABSTRACTS OF JAPAN, vol. 8, no. 278 (P-322)(1715) 19. Dezember 1984 & JP-A-59 146 054**
**IBM TECHNICAL DISCLOSURE BULLETIN, Bd. 18, Nr. 3, August 1975, NEW YORK US, Seite 715; G.T. CHIU: 'Azeotropic Mixtures for Resist Development'**

(73) Patentinhaber : **BASF Aktiengesellschaft**
**Carl-Bosch-Strasse 38**
**D-67063 Ludwigshafen (DE)**

(72) Erfinder : **Telser, Thomas, Dr.**
**Langer Wiesenweg 13**
**W 6940 Weinheim (DE)**

**EP 0 463 486 B1**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue Saint-Denis, 75001 PARIS

## Beschreibung

Die vorliegende Erfindung betrifft ein verbessertes Verfahren zur Herstellung photopolymerer flexographischer Reliefdruckplatten aus lichtempfindlichen Aufzeichnungselementen, welche

A) einen dimensionsstabilen Träger und

B) mindestens eine photopolymerisierbare lichtempfindliche Aufzeichnungsschicht mit

$b_1$) mindestens einem elastomeren Polymeren als Bindemittel,

$b_2$) mindestens einem photopolymerisierbaren Monomeren, welches mit dem Bindemittel ($b_1$) verträglich ist, und

$b_3$) mindestens einem Photopolymerisationsinitiator

enthält, durch

(1) bildmäßiges Belichten der photopolymerisierbaren lichtempfindlichen Aufzeichnungsschicht (B) mit aktinischem Licht und

(2) Auswaschen (Entwickeln) der nicht belichteten und daher nicht photopolymerisierten Bereiche der bildmäßig belichteten Aufzeichnungsschicht (B) mit einem organischen Entwicklerlösungsmittel unter Bildung einer Reliefschicht.

Ein solches Verfahren ist, sieht man von der erfindungsgemäßen Verbesserung ab, allgemein bekannt. Üblicherweise sind dabei stets als Entwicklerlösungsmittel

(i) chlorierte Kohlenwasserstoffe wie Chloroform, Trichlorethylen, Tetrachlorethylen oder Trichlorethan als solche oder als Gemische mit niederen Alkoholen wie n-Butanol;

(ii) gesättigte cyclische und acyclische Kohlenwasserstoffe wie Petrolether, Hexan, Heptan, Octan, Cyclohexan oder Methylcyclohexan;

(iii) aromatische Kohlenwasserstoffe wie Benzol, Toluol oder Xylol; oder

(iv) niedere aliphatische Ketone wie Aceton, Methylethylketon oder Methylisobutylketon verwendet worden.

Für diese bekannten Verfahrensweisen ist es stets nachteilig gewesen, daß man die Entwicklerlösungsmittel hat lange einwirken lassen müssen, um eine befriedigende Auswaschwirkung zu erzielen. Dabei sind die Reliefschichten häufig angequollen worden, oder Teile des Reliefs sind unterwaschen und unter Umständen mechanisch abgelöst worden. Außerdem sind bei der Verwendung üblicher gesättigter oder aromatischer Kohlenwasserstoffe und Ketone lange Trocknungszeiten notwendig gewesen, und häufig ist es dabei zu der gefürchteten "positiven inneren Zurichtung" gekommen, d.h. die feineren Bildelemente haben über das Niveau von Volltonflächen herausgeragt. Nicht zuletzt weisen diese Entwicklerlösungsmittel bis auf die chlorierten Kohlenwasserstoffe niedrige Flammpunkte von kleiner als 21°C auf, was die Verwendung besonderer explosionsgeschützter Anlagen zur Durchführung des Verfahrens notwendig gemacht hat. Andererseits ist es bei der Verwendung chlorierter Kohlenwasserstoffe wegen ihrer Toxizität zu Entsorgungsproblemen gekommen. Zwar weisen diese Entwicklerlösungsmittel ein vorzügliches Lösevermögen auf, indes haben die photopolymeren flexographischen Reliefdruckplatten, welche mit Hilfe dieser Entwicklerlösungsmittel hergestellt worden sind, einen unbefriedigenden Flankenaufbau und eine auffallende, runzelige Oberflächenstruktur, die sogenannte Orangenhaut, aufgewiesen.

Inzwischen sind aber die Ansprüche, welche an das anwendungstechnische Eigenschaftsprofil photopolymerer flexographischer Reliefdruckplatten in der Praxis gestellt werden, stetig weiter gewachsen. So erwartet man heutzutage von photopolymeren flexographischen Reliefdruckplatten, daß sie sich in besonders einfacher, umweltschonender, zuverlässiger Weise aus lichtempfindlichen Aufzeichnungselementen herstellen lassen, nach ihrer Herstellung die Bildvorlage vollkommen detailgetreu wiedergeben, ozonresistent sind, keine klebrige Oberfläche aufweisen, unter Druckbedingungen gegenüber den Lösungsmitteln der üblicherweise verwendeten Flexodruckfarben beständig sind und exzellente Druckerzeugnisse in besonders hoher Auflage liefern. Dieses Anforderungsprofil ist nicht nur von der stofflichen Zusammensetzung der jeweils verwendeten lichtempfindlichen Aufzeichnungselemente abhängig, sondern auch von der Art und Weise ihrer Weiterverarbeitung zu photopolymeren flexographischen Reliefdruckplatten. Es besteht daher der Zwang, die bislang bekannten Verfahrensweisen immer weiter zu entwickeln, um mit den stetig anwachsenden Ansprüchen der Praxis Schritt halten zu können.

So ist aus der EP-A-0 228 676 (US-A-4 806 452) ein Verfahrens der eingangs genannten Art bekannt, bei welchem man verzweigte oder unverzweigte, einfach bis dreifach olefinisch ungesättigte acyclische Kohlenwasserstoffe, Alkohole oder Ketone mit 8 bis 15 Kohlenstoffatomen und/oder gesättigte oder einfach bis dreifach olefinisch ungesättigte cyclische aliphatische Kohlenwasserstoffe, Alkohole oder Ketone mit 8 bis 15 Kohlenstoffatomen im Molekül als wesentliche Bestandteile der organischen Entwicklerlösungsmittel verwendet. Dabei werden als Beispiele geeigneter Kohlenwasserstoffe, Alkohole oder Ketone mit 8 bis 15 Kohlenstoffatomen 1-Octen, Cyclooctan, Cycloocten, Cyclooctanol, Cyclooctanon, 3-Nonen, Mono- und Sesquiterpene oder

Terpentinöle genannt. Von diesen werden die Monoterpene wie beispielsweise p-Menthan, Borneol, Menthon, D- und L-Limonen, α-Terpineol, α-Terpinen, γ-Terpinen, Terpinolen, α-Pinen, β-Pinen, δ-Pinen und Citronellol als vorteilhaft bezeichnet. Die organischen Entwicklerlösungsmittel, welche mindestens eine dieser Verbindungen, insbesondere aber Limonen, enthalten, können, bezogen auf ihre Gesamtmenge, etwa bis zu 40 Gew.-% an anderen Lösungsmitteln enthalten. Hierbei sollen die vom vorstehend angegebenen Stand der Technik her bekannten, insbesondere aber höhersiedende Alkohole in einer Menge von bis zu 20 Gew.-%, in Betracht kommen.

Zwar kann dieses bekannte Verfahren in nicht explosionsgeschützten Waschern durchgeführt werden und liefert dabei gute bis sehr gute photopolymere flexographische Reliefdruckplatten, indes weisen die bei diesem Verfahren verwendeten organischen Entwicklerlösungsmittel einen so intensiven Eigengeruch auf, daß die Durchführung des Verfahrens nur in besonders intensiv belüfteten Fabrikräumen möglich ist, was einen schwerwiegenden Nachteil darstellt.

Hier hat das aus der EP-A-0 332 070 bekannte Verfahren einen gewissen Fortschritt mit sich gebracht. Bei diesem bekannten Verfahren werden als organische Entwicklerlösungsmittel hydrierte Erdölfraktionen eines Siedebereiches zwischen 160 und 220°C und eines Flammpunktes von über 45°C verwendet. Diese hydrierten Erdölfraktionen sollen einen Aromatengehalt von kleiner 1 % und einen Anteil an naphthenischen Kohlenwasserstoffen zwischen 0,5 und 50 % aufweisen. Solche Produkte sind üblich und bekannt und werden beispielsweise von der Firma Exxon unter den Handelsnamen oder Warenzeichen "Exxsol D", "Nappar", "Norpar" oder "Isopar", von der Firma Esso unter dem Handelsnamen oder Warenzeichen "Shellsol D" oder von der Firma Hydrocarbures unter dem Handelsnamen oder Warenzeichen "Hydrosol P" vertrieben.

Diese Entwicklerlösungsmittel sollen außerdem Alkohole mit einer Kohlenstoffanzahl von 4 bis 8 wie n-Butanol, n-Pentanol, Isobutanol oder Hexanol enthalten können. Dabei soll der Anteil mindestens 5 Vol.%, vorzugsweise 20 Vol.%, betragen. Darüber hinaus sollen diesem bekannten organischen Entwicklerlösungsmittel noch oberflächenaktive Substanzen in einer Menge bis zu 2 Gew.-% oder geruchsverbessernde Zusatzstoffe wie Limonen, Pinen oder Citronellol in einer Menge von bis zu 10 Gew.-% zugegeben werden können.

Zwar wirft dieses bekannte Verfahren keine so schwerwiegenden Geruchsprobleme wie das aus der EP-A-0 228 676 bekannte auf und liefert auch gute bis sehr gute photopolymere flexographische Reliefdruckplatten, welche eine hervorragende Oberfläche, keine Orangenhaut und - wenn überhaupt - nur eine geringe Quellung aufweisen, indes hat die Verwendung dieser Entwicklerlösungsmittel relativ lange Auswaschzeiten zur Folge, was besonders nachteilig beim Auswaschen dicker Druckplatten ist, und es resultieren lange Trocknungszeiten, was in der betrieblichen Praxis kaum akzeptabel ist. Des weiteren kann es unter gewissen Umständen zur Bildung sogenannter Tropfnasen auf der Oberfläche der photopolymeren flexographischen Reliefdruckplatten kommen, welche von nicht gelösten oder wieder ausgefallenen Polymerresten hervorgerufen werden.

Aus der US-A-4 847 182 ist eine Variante des Verfahrens bekannt, welches aus der EP-A-0 228 676 hervorgeht. Bei dieser Verfahrensvariante werden den in der Hauptsache aus Terpenen bestehenden organischen Entwicklerlösungsmitteln sogenannte "Nicht-Lösungsmittel" wie n-Butanol, 2-Ethoxyethanol, Benzylalkohol, Ethanol, 2-Butoxyethanol, Isopropylalkohol, 2-(2-Butoxyethoxy)-ethanol, Mineralöl, "mineral spirits", Ligroin, Decan oder Octan zugesetzt. Diese "Nicht-Lösungsmittel" sollen das Ausfallen der ausgewaschenen Materialien aus dem jeweils verwendeten organischen Entwicklerlösungsmittel bewirken, so daß dessen Aufarbeitung vereinfacht wird. Des weiteren wird empfohlen, die Terpene und die "Nicht-Lösungsmittel" in der Form wäßriger Emulsionen zu verwenden. Wie aus den Beispielen der US-A-4 847 182 weiter hervorgeht, müssen dabei große Mengen an oberflächenaktiven Substanzen mitverwendet werden. Abgesehen davon, daß dieses Verfahren nicht die Probleme zu lösen vermag, welche mit dem intensiven Geruch der hierbei verwendeten Terpene verbunden sind, bereitet die Herstellung der Emulsionen in der Praxis häufig große Schwierigkeiten, weil sie in den üblicherweise verwendeten Waschern sehr stark zum Schäumen neigen.

Aus der EP-A-0 355 789 ist ein Verfahren bekannt, für welches die organischen Entwicklerlösungsmittel aus den folgenden Verbindungsklassen ausgewählt werden:

i) Diethylenglykoldialkylether mit Alkylgruppen, welche 1 bis 5 Kohlenstoffatome enthalten;

(ii) Essigsäureester von gesättigten, 6 bis 10 Kohlenstoffatome enthaltenden Alkoholen oder von 6 bis 10 Kohlenstoffatome enthaltenden, alkoxysubstituierten gesättigten Alkoholen;

(iii) Carbonsäureester von 6 bis 10 Kohlenstoffatome enthaltenden Carbonsäuren und 1 bis 6 Kohlenstoffatome enthaltenden Alkoholen sowie

(iv) Ester von 2 bis 4 Kohlenstoffatome enthaltenden, alkoxysubstituierten Carbonsäuren, worin der Alkoxyrest 1 bis 4 Kohlenstoffatome aufweist, und einem 1 bis 4 Kohlenstoffatome enthaltenden Alkohol.

Hiervon sollen Diethylenglykoldiethylether, Essigsäure-3,5,5-trimethylhexylester, Essigsäure-2-butoxyethylester (Butylglykolacetat), Essigsäure-2-ethylbutylester, Essigsäure-2-cyclohexylethylester, Essigsäure-2-ethylhexylester oder Mischungen hiervon, Octansäureethylester, Hexansäure-2-pentylester, Nonansäureethylester oder 3-Ethoxypropionsäureethylester vorteilhaft sein. Von diesen wiederum sollen 3-Ethoxypropionsäureethylester, Gemische aus Essigsäurenonylestern, Essigsäure-2-ethylhexylester und Diethylenglykoldiethylether oder Gemische aus Essigsäure-3,5,5-trimethylhexylester, Essigsäure-2-ethylhexylester und Diethylenglykoldiethylether besonders bevorzugt verwendbar sein. Außerdem sollen diese organischen Entwicklerlösungsmittel noch 5 bis 40 Volumen- oder Gewichtsprozent, welches hiervon zutrifft bleibt offen, an Alkoholen wie Butanol, Benzylalkohol oder 2-Ethylhexanol enthalten.

In der betrieblichen Praxis ist die Verwendung der Ester als organische Entwicklerlösungsmittel von großem Nachteil, weil jeder Vertreter dieser Verbindungsklasse den für ihn jeweils typischen intensiven fruchtigen Estergeruch aufweist. Dieser intensive Geruch führt zu schwerwiegenden Beeinträchtigungen des Personals im reprographischen Betrieb, welches den schon fast sprichwörtlich intensiven Estergeruch nach einer gewissen Zeit nachgerade als unerträglich empfindet. Ein weiterer Nachteil des aus der EP-A-0 355 789 bekannten Verfahrens ist, daß die hierbei verwendeten organischen Entwicklerlösungsmittel eine sehr starke Quellung der entwickelten bildmäßig belichteten Aufzeichnungsschichten (B) bewirken und die in hohem Maße unerwünschte Orangenhaut auf der druckenden Oberfläche der photopolymeren flexographischen Reliefdruckplatten hervorrufen.

Diese Nachteile treten auch bei dem aus der DE-A-38 36 402 bekannten Verfahren auf, bei welchem Ester der allgemeinen Formel I verwendet werden sollen,

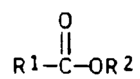

(I),

worin $R^1$ und $R^2$ gleich oder verschieden sein können und n- oder iso-Alkylreste mit 1 bis 13 Kohlenstoffatomen, Cycloalkylreste mit 5, 6 oder 12 Kohlenstoffatomen, Alkylarylreste mit 1 bis 3 Kohlenstoffatomen im Alkylrest und 6 Kohlenstoffatomen im Arylrest oder Arylreste mit 6 oder 10 Kohlenstoffatomen bezeichnen, wobei die Summe der Kohlenstoffatome in den Resten $R^1$ und $R^2$ 6 bis 13 beträgt. Hierbei sollen vor allem Essigsäure-amyl-, Essigsäure-i-amyl-, Essigsäure-hexyl-, Essigsäure-cyclohexyl-, Essigsäure-ethylhexyl-, Essigsäure-nonyl-, Essigsäure-i-nonyl-, Propionsäure-propyl-, Buttersäure-propyl-, Buttersäurebutyl-, Buttersäure-i-butyl-, Essigsäure-benzyl- oder Benzoesäure-methylester verwendet werden - allesamt Verbindungen mit intensivem Geruch.

Weitere Verfahren sind aus der DE-A- 38 36 404 und der DE-A- 38 36 403 bekannt.

Bei dem Verfahren der DE-A- 38 36 404 sollen Phenolether der allgemeinen Formel II verwendet werden,

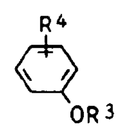

(II),

worin $R^3$ eine n- oder iso-Alkylrest mit 1 bis 6 Kohlenstoffatomen, einen Cycloalkylrest oder einen Arylrest mit 6 bis 12 Kohlenstoffatomen und $R^4$ ein Wasserstoffatom oder einen n- oder iso-Alkylrest mit 1 bis 6 Kohlenstoffatomen oder einen Rest -$OR^3$- bezeichnet. Hiervon sollen Methylphenyl-, Ethylphenyl-, Isopropylphenyl-, Propylphenyl-, o-Kresylmethyl, m-Kresylmethyl-, p-Kresylmethyl-, Resorcindimethyl- und Brenzkatechinmethylether vorteilhaft sein.

Dem gegenüber macht das Verfahren der DE-A- 38 36 403 von Aromaten der allgemeinen Formel III Gebrauch,

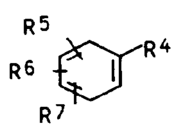

(III),

worin $R^4$ bis $R^7$ gleich oder verschieden sein können und Wasserstoffatome oder n- oder iso-Alkylreste mit 1 bis 5 Kohlenstoffatomen bedeuten, wobei $R^4$ und $R^5$, sofern sie direkt benachbart sind, auch einen cycloaliphatischen Ring mit 5 oder 6 Ringkohlenstoffatomen ausbilden können, wobei letztere vorzugsweise nicht substituiert sind und wobei die Summe der Kohlenstoffatome der Substituenten und der Ringglieder 9 bis 13 ist. Hiervon sollen vor allem Isopropylbenzol, n-Propylbenzol, 1-Methyl-3-ethylbenzol, 1,3,5-Trimethylbenzol, 1-Methyl-2-ethylbenzol, 1,2,4-Trimethylbenzol, Isobutylbenzol, sec.-Butylbenzol, 1,2,3-Trimethylbenzol, 1-Methyl-4-isopropylbenzol, Indan, Inden, 1,3-Diethylbenzol, 1-Methyl-4-propylbenzol, n-Butylbenzol, 1-Methyl-3-propylbenzol, 1,2,4,5-Tetramethylbenzol, Dimethylethylbenzol, Methylindan oder n-Pentylbenzol angewandt werden.

Diese beiden Verfahren machen zwar von Verbindungen Gebrauch, welche nicht ganz so intensiv wie die Ester, dafür aber zum Teil recht unangenehm riechen. Dadurch kann, allerdings nur graduell, die besonders intensive Geruchsbelästigung durch die Ester gemildert werden. Es verbleibt jedoch der schwerwiegende Nachteil, daß es sich bei den Entwicklerlösungsmitteln der DE-A-38 36 404 und der DE-A-38 36 403 ausschließlich um aromatische Lösungsmittel handelt, die letztlich allesamt mehr oder weniger große toxikologische, arbeitshygienische, sicherheitstechnische und ökologische Probleme aufwerfen.

Weitere Nachteile werden bei der Berücksichtigung des folgenden technischen Sachverhaltes deutlich:

Während des Auswaschens (Entwickelns) der bildmäßig belichteten Aufzeichnungsschichten (B) nehmen die belichteten und daher photopolymerisierten Bereiche der Aufzeichnungsschicht (B) Lösungsmittel auf. Dieser Vorgang wird üblicherweise als Quellung bezeichnet. Das Ausmaß der Quellung kann durch die separate Bestimmung der Schichtdickenzunahme und/oder der Gewichtszunahme der vollflächig belichteten und hiernach mit dem betreffenden Entwicklerlösungsmittel behandelten Aufzeichnungsschicht (B) quantifiziert werden. Im allgemeinen liegt in der Praxis die Quellung der bildmäßig belichteten und entwickelten Aufzeichnungsschichten (B), sprich der Reliefschichten, der photopolymeren flexographischen Reliefdruckplatten bei 5 bis 10 Gew.-%. In Schichtdicken umgerechnet, bedeutet dies beispielsweise bei einer 3 mm dicken lichtempfindlichen Aufzeichnungsschicht (B) bzw. bei der hieraus hergestellten Reliefschicht eine Schichtdickenzunahme von 150 bis 300 μm.

Durch die Trocknung soll nun das von der Reliefschicht der photopolymeren flexographischen Reliefdruckplatte aufgenommene organische Entwicklerlösungsmittel wieder entfernt werden. Hierbei wird in der Praxis oft der Fehler begangen, die Trocknung ganz zu beenden, wenn die photopolymere flexographische Reliefdruckplatte bzw. deren Reliefschicht ihre Ausgangsdicke oder ihr Ausgangsgewicht wieder erreicht hat. Dabei wird übersehen, daß die ursprüngliche bildmäßig belichtete Aufzeichnungsschicht (B) während des Auswaschens (Entwickeln) nicht nur organische Entwicklerlösungsmittel aufnimmt, sondern auch niedermolekulare Bestandteile wie z.B. Weichmacher oder andere Hilfsstoffe gegen das organische Entwicklerlösungsmittel austauscht. Es findet somit gleichzeitig eine Quellung und eine Extraktion statt, was dazu führt, daß die üblicherweise angeführten Quellwerte nicht die Quellung als solche, sondern in Wirklichkeit die Summe aus Quellung und Extraktion wiedergeben.

Wird nun bei dem in Rede stehenden Verfahren ein organisches Lösungsmittel verwendet, bei welchem der Effekt der Extraktion besonders stark ausgeprägt ist, und werden die hiermit entwickelten photopolymeren flexographischen Reliefdruckplatten bis zur tatsächlichen Gewichts- oder Dickenkonstanz getrocknet, was im allgemeinen mehrere Tage erfordert, so wird das Ausgangsgewicht bzw. die Ausgangsschichtdicke der Reliefschicht der photoplymeren Reliefdruckplatte deutlich unterschritten.

Werden dagegen der üblichen Verfahrensweise entsprechend die photopolymeren flexographischen Reliefdruckplatten nur bis zum Erreichen des Ausgangsgewichts oder der Ausgangsschichtdicke getrocknet, dann enthalten ihre Reliefschichten notwendigerweise noch hohe Anteile an organischen Entwicklerlösungsmitteln. Diese Restlösungsmittel sind aber in den Reliefschichten ungleichmäßig verteilt. So weisen feine Strukturen wie z.B. Raster mit einer großen Oberfläche pro Volumen erheblich höhere Quellwerte auf als Volltonflächen. Dies gilt auch für die Ränder von diesen Volltonflächen, welche stärker angequellen als deren Mitte. Dies hat zur Folge, daß die feinen Strukturen und die Ränder der Volltonflächen in der Reliefschicht der photopolymeren flexographischen Reliefdruckplatte höher stehen als beispielsweise die Mitte der Volltonflächen. Diese Inhomogenitäten und unterschiedlichen Höhen (Toleranzen) werden vor allem durch die stets vorhandene ungleichmäßige Temperaturverteilung im Trockner mithervorgerufen und verstärkt. Nehmen diese Toleranzen in einer photopolymeren flexographischen Reliefdruckplatte überhand, bewirken sie deren Unbrauchbarkeit.

Selbst wenn die Menge des noch vorhandenen Restlösungsmittels nicht unmittelbar zur Unbrauchbarkeit der betreffenden photopolymeren flexographischen Reliefdruckplatte führt, bewirkt es immer noch den sogenannten Langzeitschrumpf, d.h. die Reliefschicht der betreffenden photopolymeren flexographischen Reliefdruckplatte verändert durch das Verdunsten des Restlösungsmittels bei längerer Lagerung oder längerem Gebrauch ihre Dimensionen. Wegen des Langzeitschrumpfes erhält man dann mit ein und derselben photopolymeren flexographischen Reliefdruckplatte nach längerer Lager- oder Gebrauchsdauer unterschiedliche Druckergebnisse, was für die Praxis nicht akzeptabel ist. Dieser Nachteil wird in der Praxis insbesondere dann akut, wenn nach längerer Gebrauchsdauer eine der vier photopolymeren flexographischen Reliefdruckplatten eines flexographischen Vierfarbensatzes nicht mehr mitverwendet werden kann und von jetzt auf nachher durch eine neu herzustellende, im Motiv und in ihrer Dimension identische Reliefdruckplatte ersetzt werden

muß, welche den betreffenden Farbauszug zu den anderen drei Farbauszügen exakt passend druckt. Ein solcher rascher Ersatz ist aber nicht mehr möglich, wenn die photopolymeren flexographischen Reliefdruckplatten des Vierfarbensatzes einen Langzeitschrumpf erlitten haben, weil dann die neu hergestellte Reliefdruckplatte in ihren Dimensionen nicht mehr zu den übrigen drei paßt. Ist dies der Fall, bleibt nur noch der zeitraubende und teure Ausweg, alle vier Reliefdruckplatten des Vierfarbensatzes neu herzustellen.

Abgesehen davon, daß es in hohem Maße wünschenswert ist, die Nachteile der bislang bekannten Verfahren durch Variation ihrer Parameter, insbesondere der organischen Entwicklerlösungsmittel, zu vermindern oder gar ganz zu beseitigen, müssen bei der Erfolgskontrolle auch noch andere Meßmethoden angewandt werden. So sollte sich die notwendige Dauer der Trocknung nicht nach dem Erreichen der Ausgangsschichtdicke oder des Ausgangsschichtgewichts richten, sondern danach, wann die Toleranzen der Reliefschichten der photopolymeren Reliefdruckplatten einen Minimalwert erreicht haben, wobei die Angabe der Toleranzen noch durch eine Flächenangabe und die Angabe der Zahl der Meßstellen auf der Reliefschicht zu ergänzen wäre. Diese Angaben spezifizierten in ihrer Gesamtheit eine Trocknungszeit, bei welcher die Menge an Restlösungsmittel in der photopolymeren flexographischen Reliefdruckplatte einen Wert erreicht hätte, welcher die Brauchbarkeit der photopolymeren flexographischen Reliefdruckplatte unter Praxisbedingungen nicht mehr länger verminderte oder gar vollständig zunichte machte. Ohne solche detaillierten Angaben kann keine Erfolgskontrolle durchgeführt werden, und eine Vergleichbarkeit von organischen Entwicklerlösungsmitteln untereinander ist nicht gewährleistet.

Ansonsten werden in den beiden nicht vorveröffentlichten älteren deutschen Patentanmeldungen P 3908764.6 und P 3908763.8 Verfahren der eingangs genannten Art beschrieben, bei welchen Emulsionen aus organischen Entwicklerlösungsmitteln und Wasser verwendet werden. Hierbei kommen als organische Entwicklerlösungsmittel chlorierte Kohlenwasserstoffe, gesättigte und/oder ungesättigte cyclische Kohlenwasserstoffe, gesättigte und/oder ungesättigte acyclische Kohlenwasserstoffe, Petroleumdestillate, hydrierte Erdölfraktionen und/oder deren Gemische in Betracht, sofern sie jeweils für sich selbst gesehen bereits nichtbrennbar, schwerbrennbar und/oder hochsiedend sind. Außerdem kommen Gemische langkettiger Alkylester mit Alkylgruppen unterschiedlicher Kettenlänge, welche indes nicht näher spezifiziert werden, in Betracht. Diese Emulsionen können außerdem noch 0,1 bis 20 Vol.% mindestens eines Alkohols wie etwa n-Butanol, n-Pentanol, n-Hexanol, Cyclohexanol, n-Heptanol, n-Octanol, n-Decanol, Laurylalkohol, 3-Methyl-3-methoxybutanol, Benzylalkohol oder 2,3,5-Trimethylhexanol enthalten.

Aufgabe der vorliegenden Erfindung ist es, das eingangs genannte Verfahren weiter zu entwickeln, um so zu einem neuen, verbesserten Verfahren zur Herstellung einer flexographischen Reliefdruckplatte aus einem lichtempfindlichen Aufzeichnungselement zu gelangen, welches - auch unter Berücksichtigung exakter Vergleichskriterien - die vorstehend genannten Nachteile des Standes der Technik nicht mehr länger aufweist.

Zur Lösung dieser Aufgabe hat überraschenderweise die Erkenntnis beigetragen, daß die Kombination zweier für den hier in Rede stehenden Verwendungszweck bekannter und in ihren Siedepunkten bzw. ihren Siedebereichen aneinander angepaßter organischer Entwicklerlösungsmittel die spezifischen Nachteile der jeweiligen einzeln angewandten organischen Entwicklerlösungsmittel überwindet und darüber hinaus auch noch überraschende Vorteile mit sich bringt, welche im Hinblick auf den Stand der Technik nicht zu erwarten waren. Insbesondere war der Befund überraschend, daß schon durch einen vergleichsweise geringen Zusatz von Essigsäureestern zu entaromatisierten Erdölfraktionen, die für Essigsäureester typischen kurzen Auswasch- und Trocknungszeiten erreicht oder sogar unterschritten werden konnten, ohne daß es zu einer übermäßig starken Geruchsbelästigung gekommen wäre oder daß Quellungsschäden an den mit der Entwicklerlösungsmittelkombination hergestellten photopolymeren flexographischen Reliefdruckplatten aufgetreten wären.

Bei dem Gegenstand der vorliegenden Erfindung handelt es sich demnach um ein neues Verfahren zur Herstellung einer photopolymeren flexographischen Reliefdruckplatte aus einem lichtempfindlichen Aufzeichnungselement, welches

A) einen dimensionsstabilen Träger und

B) mindestens eine photopolymerisierbare Aufzeichnungsschicht mit

$b_1$) mindestens einem elastomeren Polymeren als Bindemittel,

$b_2$) mindestens einem photopolymerisierbaren Monomeren, welches mit dem Bindemittel ($b_1$) verträglich ist, und

$b_3$) mindestens einem Photopolymerisationsinitiator

enthält, durch

(1) bildmäßiges Belichten der photopolymerisierbaren lichtempfindlichen Aufzeichnungsschicht (B) mit aktinischem Licht und

(2) Auswaschen (Entwickeln) der nicht belichteten und daher nicht photopolymerisierten Bereiche der bildmäßig belichteten Aufzeichnungsschicht (B) mit einem organischen Entwicklerlösungsmittel unter Bildung

einer Reliefschicht,
wobei das neue, verbesserte Verfahren dadurch gekennzeichnet ist, daß das hierbei verwendete organische Entwicklerlösungsmittel, bezogen auf seine Gesamtmenge, 10 bis 95 Vol.% mindestens einer entaromatisierten Erdölfraktion eines Siedebereiches zwischen 150 und 260°C und eines Flammpunktes von über 45°C sowie 90 bis 5 Vol.% mindestens eines in seinem Siedepunkt oder Siedebereich an den Siedebereich der entaromatisierten Erdölfraktion angepaßten Essigsäureesters eines gesättigten Alkohols mit mindestens 6 Kohlenstoffatomen im Alkylrest und/oder eines alkoxysubstituierten gesättigten Alkohols mit insgesamt mindestens 3 Kohlenstoffatomen im Alkoxyalkylrest und/oder mindestens eines Glykolsäurealkyl- und/oder -alkoxyalkylesters enthält.

Im folgenden wird das neue, verbesserte Verfahren zur Herstellung einer photopolymeren flexographischen Reliefdruckplatte aus einem lichtempfindlichen Aufzeichnungselement der Kürze halber als "erfindungsgemäßes Verfahren" bezeichnet.

Im Rahmen der vorliegenden Erfindung bedeutet "verträglich" die Eigenschaft zweier oder mehrerer Komponenten, vollständig miteinander mischbar zu sein und sich auch nicht nach längerer Lagerungszeit wieder zu entmischen.

Im Rahmen der vorliegenden Erfindung weist das Merkmal "angepaßt" darauf hin, daß die betreffenden Siedepunkte oder Siedebereiche von zwei und mehr Verbindungen oder Stoffgemischen sich entweder nicht allzusehr, d.h. nicht mehr als etwa 10 bis 30°C, voneinander unterscheiden oder in etwa oder exakt übereinstimmen, so daß die betreffenden Verbindungen oder Stoffgemische in einfacher Weise zusammen destilliert werden können.

Das erfindungsgemäß wesentliche Merkmal des erfindungsgemäßen Verfahrens ist die Verwendung einer organischen Entwicklerlösungsmittelkombination, welche für den hier in Rede stehenden Zweck bislang noch nicht angewandt worden ist.

Das erfindungsgemäß zu verwendende organische Entwicklerlösungsmittel enthält, bezogen auf seine Gesamtmenge, 10 bis 95 Vol.% mindestens einer der nachstehend näher spezifizierten entaromatisierten Erdölfraktionen und 90 bis 5 Vol.% mindestens eines der nachstehend näher spezifizierten Ester. Dies bedeutet, daß die Zusammensetzung des erfindungsgemäß zu verwendenden organischen Entwicklerlösungsmittels innerhalb breiter Grenzen variiert werden kann, ohne daß die mit Hilfe des erfindungsgemäßen Verfahrens erhaltenen besonderen Vorteile verlustig gehen. Innerhalb dieser breiten Grenzen hat sich die Zusammensetzung, welche, bezogen auf ihre Gesamtmenge, 40 bis 95 Vol.% mindestens einer der nachstehend spezifizierten entaromatisierten Erdölfraktionen und 60 bis 5 Vol.% mindestens eines der nachstehend näher spezifizierten Ester enthält, im Hinblick auf eine geringe Geruchsbelästigung verbunden mit einer kurzen Auswasch- und Trocknungszeit bewährt. Besondere Vorteile ergeben sich für das erfindungsgemäße Verfahren, wenn das organische Entwicklerlösungsmittel, bezogen auf seine Gesamtmenge, 5 bis 20 Vol.% mindestens eines der nachstehend näher spezifizierten Ester enthält. Die erfindungsgemäß zu verwendenden organischen Entwicklerlösungsmittel dieser Zusammensetzung weisen eine besonders geringe Geruchsbelästigung auf und liefern bei kurzen Auswasch- und Trocknungszeiten photopolymere flexographische Reliefdruckplatten mit vorzüglichen Reliefschichten, welche frei von jeglicher Orangenhaut sind.

Beispiele geeigneter erfindungsgemäß zu verwendender entaromatisierter Erdölfraktionen sind hydrierte Erdölfraktionen.

Beispiele gut geeigneter erfindungsgemäß zu verwendender hydrierter Erdölfraktionen sind Testbenzine, welche einen Siedebereich von 150 bis 220°C, einen Flammpunkt von über 45°C, einen Aromatengehalt von <1 %, einen Gehalt an naphthenischen Kohlenwasserstoffen von 35 % und einen Gehalt an Paraffinen von >64 % aufweisen; synthetische Isoparaffine, welche einen Siedebereich von 180 bis 220°C, einen Flammpunkt von über 65°C und einen Gehalt an Paraffinen von >99 % aufweisen; n-Paraffin-Fraktionen, welche einen Siedebereich von 180 bis 230°C, einen Flammpunkt oberhalb 55°C, einen Aromatengehalt von <0,1 % und einen Paraffingehalt von >99,9 % aufweisen; und hydrierte Mineralöle, welche einen Siedebereich von 220 bis 260°C, einen Flammpunkt von 90°C und höher, einen Aromatengehalt von 3 %, einen Gehalt an naphthenischen Kohlenwasserstoffen von 31 % und einen Paraffingehalt von 66 % aufweisen. Von diesen sind diejenigen hydrierten Erdölfraktionen bevorzugt, welchen einen Siedebereich zwischen 150 und 220°C haben.

Diese hydrierten Erdölfraktionen sind übliche und bekannte Handelsprodukte und werden von der Firma Exxon unter dem Handelsnamen oder Warenzeichen "Exxsol D", "Nappar", "Norpar" oder "Isopar", von der Firma Esso unter dem Handelsnamen oder Warenzeichen "Shellsol D" oder von der Firma Hydrocarbures unter dem Handelsnamen oder Warenzeichen "Hydrosol P" vertrieben.

Beispiele gut geeigneter erfindungsgemäß zu verwendender Ester der Essigsäure mit gesättigten Alkoholen mit mindestens 6 Kohlenstoffatomen im Alkylrest sind Esssigsäure-3,5,5-trimethylhexylester, Essigsäurehexylester, Essigsäure-2-ethylbutylester, Essigsäureisoheptylester, Essigsäureisooctylester, Essigsäureisononylester, Essigsäure-2-cyclohexylethylester, Essigsäure-2-ethylhexylester, Mischungen hiervon oder die

technischen Estergemische, welche die Firma Exxon unter den Handelsnamen oder Warenzeichen Exxate 600, 700 oder 900 vertreibt. Hierbei werden diejenigen Alkylester erfindungsgemäß besonders bevorzugt verwendet, welche in ihrem Siedepunkt oder in ihrem Siedebereich dem Siedebereich der jeweils verwendeten hydrierten Erdölfraktion angepaßt sind.

Von den vorstehend genannten Alkylestern werden das technische Estergemisch Exxate 700 oder der Essigsäure-3,5,5-trimethylhexylester ganz besonders bevorzugt verwendet.

Beispiele gut geeigneter erfindungsgemäß zu verwendender Ester der Essigsäure mit alkoxysubstituierten gesättigten Alkoholen mit insgesamt mindestens 3 Kohlenstoffatomen im Alkoxyalkylrest sind Essigsäure-(2-methoxyethyl)-(Methylcellosolveacetat), -(1-methoxyethyl)-, -(3-methoxypropyl)-, -(2-methoxypropyl)-, -(1-methoxypropyl)-, -(2-ethoxyethyl)-(Cellosolveacetat), -(1-ethoxyethyl)-, -(n-propoxymethyl)-, -(i-propoxymethyl)-, -(4-methoxy-n-butyl)-, -(3-methoxy-n-butyl)-, -(2-methoxy-n-butyl)-, -(1-methoxy-n-butyl)-, -(2-methyl-3-methoxy-prop-2-yl)-, -(2-methyl-2-methoxy-prop-2-yl)-, -(3-methoxy-but-2-yl)-, -(1-methoxy-but-2-yl)-, -(2-methoxy-but-2-yl)-, -(2-methyl-1-methoxy-prop-1-yl)-, -(3-ethoxy-n-propyl)-, -(2-ethoxy-n-propyl)-, -(1-ethoxy-n-propyl)-, -(3-ethoxy-prop-2-yl)-, -(2-ethoxy-prop-2-yl)-, -(2-n-propoxy-ethyl)-, -(1-n-propoxy-ethyl)-, -(2-i-propoxy-ethyl)-, -(1-i-propoxy-ethyl)-, -(n-butoxy-methyl)-, -(tert.-butoxy-methyl)-, -(but-2-yloxy-methyl)-, -(2-n-butoxy-ethyl)-, -(3-n-propoxy-propyl)-, -(3-i-propoxy-propyl)-, -(4-ethoxy-n-butyl)-, -(5-methoxy-n-pentyl)-, -(4-methoxy-pentyl)- und der Essigsäure-(3-methoxy-pentyl)-ester. Hierbei werden diejenigen Alkoxyalkylester besonders bevorzugt verwendet, welche in ihrem Siedepunkt oder Siedebereich dem Siedebereich der jeweils verwendeten hydrierten Erdölfraktion angepaßt sind.

Von all diesen Alkoxyalkylestern sind Essigsäure-(3-methoxy-n-butyl)- und -(2-n-butoxy-ethyl)-ester ganz besonders vorteilhaft.

Beispiele gut geeigneter erfindungsgemäß anzuwendender Alkyl- und Alkoxyalkylester der Glykolsäure sind Glykolsäure-methyl-, -ethyl-, -n-propyl-, -i-propyl-, -n-butyl-, -sec.-butyl-, -tert.-butyl-, -n-pentyl-, -2-pentyl-, 3-pentyl-, -(2,2-dimethyl-prop-1-yl)-, -(1,1-dimethyl-prop-1-yl)-, -(3-methoxy-n-propyl)-, -(2-methoxy-ethyl)-, -(2-ethoxy-ethyl)-, -(3-methoxy-n-butyl)- und der Glykolsäure-(2-propoxy-ethyl)-ester. Hierbei werden diejenigen Ester besonders bevorzugt verwendet, welche in ihrem Siedepunkt oder Siedebereich dem Siedebereich der jeweils verwendeten hydrierten Erdölfraktion angepaßt sind.

Von all diesen Glykolsäureestern ist Glykolsäure-n-butylester besonders vorteilhaft.

Die erfindungsgemäß zu verwendenden organischen Entwicklerlösungsmittel können noch Alkohole enthalten, welche u.a. den Zweck haben, eine alkohollösliche Deckschicht (C), welche sich gegebenenfalls auf der Oberfläche des lichtempfindlichen Aufzeichnungselements bzw. dessen photopolymerisierbarer lichtempfindlicher Aufzeichnungsschicht (B) befindet, in dem betreffenden organischen Entwicklerlösungsmittel löslich oder dispergierbar zu machen. Indes kann besagte Deckschicht (C) auch in einem separaten Wasch- oder Entwicklungsschritt mit Hilfe dieser Alkohole weggewaschen werden, wobei es für das erfindungsgemäße Verfahren von Vorteil ist, den Alkohol dem erfindungsgemäß zu verwendenden organischen Entwicklerlösungsmittel zuzusetzen, weil hierdurch ein separater Waschschritt eingespart werden kann.

Für den erfindungsgemäßen Verwendungszweck sind alle Alkohole geeignet, welche in ihrem Siedepunkt oder in ihrem Siedebereich den Siedepunkten oder Siedebereichen der jeweils verwendeten hydrierten Erdölfraktionen und Ester angepaßt sind.

Beispiele besonders gut geeigneter Alkohole sind n-Butanol, n-Pentanol, 2-Ethylhexanol, Isoheptanol, Isooctanol, Isononanol, 3,5,5-Trimethylhexanol, Benzylalkohol, die technischen Alkoholgemische, welche von der Firma Exxon unter den Handelsnamen oder Warenzeichen Exxal 7, 8 und 9 vertrieben werden, sowie die alkoxysubstituierten Alkohole 2-n-Propoxy-ethanol, 2-i-Propoxy-ethanol, 4-Methoxy-n-butanol, 3-Methoxy-n-butanol, 4-Ethoxy-n-butanol, 2-Ethoxy-ethanol, 2-n-Butoxyethanol, 3-Methyl-3-methoxy-n-butanol und 5-Methoxy-n-pentanol.

Hierbei ist es für das erfindungsgemäße Verfahren von ganz besonderem Vorteil, Alkohole und Ester mit dem gleichen Alkoxyalkyl- oder Alkylrest Zu verwenden. Die hieraus resultierenden organischen Entwicklerlösungsmittel können dann nach ihrem erfindungsgemäßen Gebrauch durch Vakuumdestillation in einfacher Weise wiederaufgearbeitet werden, ohne daß hierbei eine Änderung der Zusammensetzung des Destillats gegenüber dem ursprünglichen organischen Entwicklerlösungsmittel durch Umesterungsreaktionen Zu befürchten wäre.

Methodisch gesehen bietet das erfindungsgemäße Verfahren keine Besonderheiten, d.h. man entwickelt die in üblicher und bekannter Weise bildmäßig belichteten photopolymerisierbaren Aufzeichnungsschichten (B) lichtempfindlicher Aufzeichnungselemente durch Auswaschen der nicht belichteten und daher nicht photopolymerisierten Bereiche der bildmäßig belichteten Aufzeichnungsschichten (B) mit den vorstehend beschriebenen erfindungsgemäß anzuwendenden Entwicklerlösungsmitteln in den bekannten Sprüh-, Bürsten- und Reibewaschern bei Temperaturen von 20 bis 60°C, insbesondere 20 bis 35°C. Bereits hierbei zeigt sich ein nicht zu unterschätzender Vorteil des erfindungsgemäßen Verfahrens, welcher darin liegt, daß keine explosionsgeschützten Wascher verwendet werden müssen. Außerdem zeigt es sich, daß die optimalen Auswaschzeiten des erfindungsgemäßen Verfahrens deutlich kürzer sind als die der bekannten Verfahrensweisen und daß es dabei - im Gegensatz zu den bekannten Verfahrensweisen - beim Überschreiten der optimalen Auswaschzeiten nicht zur sogenannten Überwaschung, d.h. dem Herausbrechen von Material aus der Reliefschicht der photopolymeren flexographischen Reliefdruckplatten durch mechanische Einwirkung (Kantenausbruch) kommt. Unter optimaler Auswaschzeit ist dabei die Zeit zu verstehen, in welcher man beim Auswaschen gerade die jeweils gewünschte oder die maximale Relieftiefe erreicht. Die mit Hilfe des erfindungsgemäßen Verfahrens hergestellten photopolymeren flexographischen Reliefdruckplatten bzw. deren Reliefschichten haben eine stärker ausgeprägte Tiefe und einen sehr guten Flankenaufbau, wobei die Oberfläche dieser Reliefschichten überraschenderweise deutlich glatter und gleichmäßiger ist als die Oberfläche von Reliefschichten, welche nach den bekannten Verfahrensweisen hergestellt worden sind. Insbesondere weisen die nach dem erfindungsgemäßen Verfahren hergestellten Reliefschichten keine Orangenhaut mehr auf. Des weiteren ist die Quellung der Bildelemente in den Reliefschichten deutlich geringer als bei der Verwendung üblicher Entwicklerlösungsmittel, und die in erfindungsgemäßer Verfahrensweise hergestellten photopolymeren flexographischen Reliefdruckplatten haben eine deutlich geringere Neigung zur Rißbildung. Ein zusätzlicher überraschender Vorteil des erfindungsgemäßen Verfahrens ist, daß es - selbst nach längerem Betrieb - in den Waschern und auf den hergestellten photopolymeren flexographischen Reliefdruckplatten nicht zu Ablagerungen kommt.

Bei der Durchführung des erfindungsgemäßen Verfahrens geht dem Entwicklungsschritt eine übliche und bekannte bildmäßige Belichtung des lichtempfindlichen Aufzeichnungselements bzw. dessen photopolymerisierbarer Aufzeichnungsschicht (B) mit aktinischem Licht einer Wellenlänge $\lambda$ von 230 bis 450, insbesondere 300 bis 450 nm voraus. Hierfür geeignete Lichtquellen sind z.B. die Strahlung der Sonne, handelsübliche UV-Fluoreszenzröhren, Quecksilbermittel-, -hoch- und -niederdruckstrahler, superaktinische Leuchtstoffröhren, Xenonimpulslampen, mit Metalliodiden dotierte Lampen oder Kohlebogenlampen.

Dem Entwicklungsschritt schließt sich im weiteren Ablauf des erfindungsgemäßen Verfahrens die Trocknung der hieraus resultierenden photopolymeren flexographischen Reliefdruckfplatten an. Vorteilhafterweise erfolgt die Trocknung in Trocknergeräten wie beispielsweise Umlufttrockner bei Temperaturen oberhalb der Raumtemperatur, insbesondere oberhalb 40°C. Vorteilhafterweise wird die Trocknung der aus dem erfindungsgemäßen Verfahren resultierenden photopolymeren flexographischen Reliefdruckplatten so lange durchgeführt, bis die Toleranzen in ihren Reliefschichten $\leqq 20$, insbesondere $\leqq 15$ µm, erreicht haben. Hiernach weisen die in erfindungsgemäßer Verfahrensweise hergestellten photopolymeren flexographischen Reliefdruckplatten auch keinen Langzeitschrumpf mehr auf, was die Grundvoraussetzung für ihre vorzügliche Wiederverwendbarkeit ist.

Vorteilhafterweise werden die Toleranzen der Reliefschichten separat an Volltonflächen des Formats DIN A3 anhand von 40 Meßstellen bestimmt.

Anschließend können die in erfindungsgemäßer Verfahrensweise erhaltenen photopolymeren flexographischen Reliefdruckplatten noch in Halogen enthaltenden oder liefernden Bädern halogeniert, in reduzierenden Bädern nachgewaschen und erneut getrocknet werden. Alternativ oder im Nachgang zu dieser Behandlung können die photopolymeren flexographischen Reliefdruckplatten noch mit aktinischem Licht, insbesondere Licht einer Wellenlänge $\lambda$ von $\leqq 250$ nm, vollflächig belichtet werden.

Ein weiterer Vorteil des erfindungsgemäßen Verfahrens ist es, daß es an zahlreichen bekannten, für die Herstellung photopolymerer flexographischer Reliefdruckplatten geeigneten lichtempfindlichen Aufzeichnungselementen mit gutem Erfolg ausgeführt werden kann. Solche bekannten lichtempfindlichen Aufzeichnungselemente umfassen

A) einen dimensionsstabilen Träger und

B) mindestens eine photopolymerisierbare lichtempfindliche Aufzeichnungsschicht, welche

$b_1$) mindestens ein elastomeres Polymer als Bindemittel,

$b_2$) mindestens ein photopolymerisierbares Monomeres, welches mit dem polymeren Bindemittel ($b_1$) verträglich ist, und

$b_3$) mindestens einen photopolymerisationsinitiator enthält,

und werden von der Fachwelt auch etwas ungenau als "Flexodruckplatten" bezeichnet.

Die photopolymerisierbaren Aufzeichnungsschichten (B) dieser Flexodruckplatten können außer den essentiellen Komponenten ($b_1$), ($b_2$) und ($b_3$) noch geeignete Zusätze wie Inhibitoren der thermisch initiierten Polymerisation, Farbstoffe, Pigmente, photochrome Stoffe, Lichthofschutzmittel, Weichmacher, Antioxidantien, Antiozonantien, Mittel zur Verbesserung der Reliefstruktur, Vernetzungshilfsmittel, Flußmittel, Trennmittel, Füllmittel und/oder Verstärkerfüllstoffe in wirksamen Mengen enthalten. Hierbei können die Flexodruckplatten mehrere dieser photopolymerisierbaren Aufzeichnungsschichten (B) übereinanderliegend und haftfest miteinander verbunden enthalten, wobei diese Schichten (B) von stofflich gleicher, in etwa gleicher oder unterschiedlicher Zusammensetzung sein können. Das lichtempfindliche Aufzeichnungselement kann außerdem noch eine übliche und bekannte Deckschicht (C) aus einem alkohollöslichen Polymeren, wie beispielsweise einem Polyamid, enthalten. Sofern die Deckschicht (C) mitverwendet wird, liegt sie der photopolymerisierbaren Aufzeichnungsschicht (B) des lichtempfindlichen Aufzeichnungselements oder der Flexodruckplatte direkt auf.

Für das erfindungsgemäße Verfahren ist es weiterhin von großem Vorteil, daß die erfindungsgemäß zu verwendenden organischen Entwicklerlösungsmittel an zahlreichen bekannten photopolymerisierbaren lichtempfindlichen Aufzeichnungsschichten (B) mit Erfolg angewandt werden können.

So ergeben sich beispielsweise kurze Auswaschzeiten bei photopolymerisierbaren lichtempfindlichen Aufzeichnungsschichten (B), welche als Bindemittel ($b_1$) Vinylaromat-Alkadien-Blockmischpolymerisate (Styrol-Isopren-Styrol, Styrol-Butadien-Styrol, Styrol-Isopren-Styrol/Butadien, etc.), Alkadien-Acrylnitril-Copolymerisate (Butadien-Acrylnitril), Fluorkautschuke (Vinylidenchlorid-Hexafluorpropylen-Copolymerisate), Naturkautschuke, Silikonpolymerisate, Polysulfidkautschuke oder Ethylen-Propylen-Dien-Terpolymere enthalten.

Die nach dem erfindungsgemäßen Verfahren hergestellten photopolymeren flexographischen Reliefdruckplatten sind nach ihrem Aufspannen auf Druckzylinder in hervorragender Weise für den Endlosdruck geeignet. Hierbei erweisen sie sich als ausgesprochen stabil gegenüber den Lösungsmitteln der üblicherweise verwendeten Flexodruckfarben und liefern exzellente Druckerzeugnisse in besonders hoher Auflage. Nach ihrem Gebrauch können sie längere Zeit gelagert und danach wiederverwendet werden, ohne daß eine Veränderung des Druckbildes zu befürchten wäre.

Beispiele und Vergleichsversuche

Beispiele 1 und 2 und Vergleichsversuche 1 bis 4

Die Herstellung photopolymerer flexographischer Reliefdruckplatten nach dem erfindungsgemäßen Verfahren (Beispiele 1 und 2) und nach bekannten Verfahren (Vergleichsversuche 1 bis 4)

Allgemeine Versuchsvorschrift:

Für die Beispiele 1 und 2 und die Vergleichsversuche 1 bis 4 wurden handelsübliche Flexodruckplatten (lichtempfindliche Aufzeichnungselemente) verwendet. Diese enthielten als Trägerfolie (A) eine 125 µm dicke Polyethylenterephthalatfolie, welche vor dem Aufbringen der photopolymerisierbaren lichtempfindlichen Aufzeichnungsschicht (B) mit einer 0,3 µm dicken Polyurethan-Haftlackschicht beschichtet wurde. Die 2900 µm dicke photopolymerisierbare lichtempfindliche Aufzeichnungsschicht (B) dieser Flexodruckplatten bestand aus

- 82,616 Gew.-% eines Blockmischpolymerisates XYZ mit einer Viskositätszahl von 164,9 ml/g und einer Gesamtmolmasse von 190.000, bestehend aus, bezogen auf XYZ, 10 Gew.-% Polystyrol als X-Block, 70 Gew.-% Polyisopren einer Glastemperatur $T_g$ von -53°C als Y-Block und 20 Gew.-% Polyisopren mit einem Gehalt von 53 Gew.-% an 3,4-Strukturen und einer Glastemperatur $T_g$ von +10°C als Z-Block
- 5 Gew.-% Weißöl S 5000
- 5 Gew.-% eines Copolymerisats aus α-Methylstyrol (10 Gew.-%) und p-Methylstyrol (90 Gew.-%) mit einem massenmittleren Molekulargewicht $\overline{M}_w$ von $9 \cdot 10^3$
- 3,33 Gew.-% Hexan-1,6-diol-diacrylat
- 1,65 Gew.-% Hexan-1,6-diol-dimethacrylat
- 1,2 Gew.-% Benzildimethylacetal
- 0,198 Gew.-% 2,6-Di-tert.-butyl-p-kresol
- 1,00 Gew.-% des Ozonschutzwachses Antilux® 550 der Firma Rheinchemie und
- 0,006 Gew.-% des Farbstoffs Solvent Black (C.I. 26 150).

Außerdem enthielten die Flexodruckplatten eine 2 µm dicke Deckschicht (C) aus einem alkohollöslichen Polyamid (Makromelt® 6900 der Firma Henkel). Diese Flexodruckplatten wurden zunächst während 2 Minuten von ihrer Rückseite her in einem Röhrenbelichter vollflächig vorbelichtet, anschließend durch eine der Deckschicht (C) aufgelegten Testnegativvorlage hindurch während 12 Minuten bildmäßig belichtet und hiernach bei 30°C in dem nicht explosionsgeschützten Trommelbürstenwascher nyloflex® F II der Firma BASF Aktiengesellschaft in erfindungsgemäßer (Beispiele 1 und 2) und in üblicher und bekannter (Vergleichsversuche 1 bis 4) Weise entwickelt, wobei die Auswaschzeit bestimmt wurde, welche für das Erreichen einer Relieftiefe von 800 µm jeweils benötigt wurde (= optimale Auswaschzeit).

Die resultierenden photopolymeren flexographischen Reliefdruckplatten wurden anschließend in einem Umlufttrockenschrank bei 60°C getrocknet. Hierbei wurde die Zeit bestimmt, nach welcher die Reliefschichten ihre Ausgangsschichtdicke (2900 µm) wieder erreicht hatten. Hiernach wurde, falls dies überhaupt noch notwendig war, die Trocknung solange fortgesetzt, bis die Reliefschichten der photopolymeren flexographischen Reliefdruckplatten Toleranzen von ≦ 20 µm erreichten und unterschritten.

Die hierfür notwendige Trocknungszeit wurde für jede Flexodruckplatte und für jedes Entwicklerlösungsmittel separat an vollflächig belichteten und ansonsten wie vorstehend beschrieben behandelten Flexodruckplatten des Formats DIN A3 anhand von 40 Meßstellen, an denen die Schichtdicke und die Toleranzen in Abhängigkeit von der Trocknungsdauer gemessen wurden, bestimmt.

Die Tabelle gibt einen Überblick über die angewendeten organischen Entwicklerlösungsmittel und die erhaltenen Versuchsergebnisse.

Die Versuchsergebnisse untermauern die Vorteilhaftigkeit der erfindungsgemäß zu verwendenden organischen Entwicklerlösungsmittel: wegen ihres nur mäßig intensiven Geruchs belästigten sie das Bedienungspersonal des Trommelbürstenwaschers nicht in dem Ausmaß, wie dies bei einem Teil der üblicherweise verwendeten Entwicklerlösungsmittel der Fall war. Die Trocknungszeiten waren kurz und lagen zum Teil unter denen der Vergleichsversuche. Nicht zuletzt wiesen die in erfindungsgemäßer Verfahrensweise hergestellten photopolymeren flexographischen Reliefdruckplatten keine Orangenhaut auf.

Die bei dem erfindungsgemäßen Verfahren angewandten organischen Entwicklerlösungsmittel, insbesondere aber dasjenige des Beispiels 2, konnten in einfacher Weise durch Vakuumdestillation wieder aufgearbeitet werden, ohne daß es hierbei zu der Anreicherung einer Komponente der organischen Entwicklerlösungsmittel im Destillat oder zu Umesterungsreaktionen gekommen wäre. Die Destillate konnten daher direkt für den erfindungsgemäßen Verwendungszweck wiederverwendet werden.

Tabelle: Die Herstellung photopolymerer flexographischer Reliefdruckplatten in erfindungsgemäßer (Beispiele 1 und 2) und nicht erfindungsgemäßer (Vergleichsversuche 1 bis 4) Verfahrensweise

| Beispiele | organisches Entwicklerlösungsmittel Zusammensetzung hydrierte Erdölfraktion [Vol.-%] | Essigsäureester [Vol.-%] | Alkohol [Vol.-%] | Geruch | Versuchsergebnisse Auswaschzeit bis 800 µm Relieftiefe (min) | Trocknungszeit bis Ausgangsschichtdicke (h) | Zeit zum Erreichen von Toleranzen ≤ 20 µm (h) | Oberflächenstrukturen |
|---|---|---|---|---|---|---|---|---|
| 1 | Exxsol D 60a) [40] | Exxate 700b) [40] | n-Pentanol [20] | mäßig intensiv | 5 | 2 | 2 | keine |
| 2 | Exxsol D 60a) [72] | Essigsäure-3,5,5-trimethylhexylester [8] | 3,5,5-Trimethylhexanol [20] | mäßig intensiv | 6 | 2 | 2 | keine |
| Vergleichsversuche | | | | | | | | |
| 1 | Exxsol D 60a) [80] | - | n-Pentanol [20] | mäßig intensiv | 12 | 3 | 3 | keine |
| 2 | - | Exxate 700b) [80] | n-Pentanol [20] | sehr intensiv, unangenehm | 7 | 2 | 3 | Orangenhaut |
| 3 | Exxsol D 60a) [80] | - | 3,5,5-Trimethylhexanol [20] | mäßig intensiv | 13 | 3 | 3 | keine |

Tabelle (Forts.)

| Beispiele | organisches Entwicklerlösungsmittel Zusammensetzung | | | Geruch | Versuchsergebnisse | | | |
|---|---|---|---|---|---|---|---|---|
| | hydrierte Erdölfraktion [Vol.-%] | Essigsäureester [Vol.-%] | Alkohol [Vol.-%] | | Auswaschzeit bis 800 µm Relieftiefe (min) | Trocknungszeit bis Ausgangsschichtdicke (h) | Zeit zum Erreichen von Toleranzen ≤ 20 µm (h) | Oberflächenstrukturen |
| 4 | - | Essigsäure-1,3,5-trimethylhexylester [80] | 2-Ethylhexanol [20] | sehr intensiv, unangenehm | 7 | 2 | 3 | Orangenhaut |

a) Handelsname oder Warenzeichen der Firma Exxon;

b) technisches Estergemisch, Handelsname oder Warenzeichen der Firma Exxon;

## Patentansprüche

1. Verfahren zur Herstellung einer photopolymeren flexographischen Reliefdruckplatte aus einem lichtempfindlichen Aufzeichnungselement, welches
   A) einen dimensionsstabilen Träger und
   B) mindestens eine photopolymerisierbare Aufzeichnungsschicht mit
      $b_1$) mindestens einem elastomeren Polymeren als Bindemittel,
      $b_2$) mindestens einem photopolymerisierbaren Monomeren, welches mit dem Bindemittel ($b_1$) verträglich ist, und
      $b_3$) mindestens einem Photopolymerisationsinitiator

   enthält, durch
   (1) bildmäßiges Belichten der photopolymerisierbaren Aufzeichnungsschicht (B) mit aktinischem Licht und
   (2) Auswaschen (Entwickeln) der nicht belichteten und daher nicht photopolymerisierten Bereiche der bildmäßig belichteten Aufzeichnungsschicht (B) mit einem organischen Entwicklerlösungsmittel unter Bildung einer Reliefschicht,

   dadurch gekennzeichnet, daß das hierbei verwendete organische Entwicklerlösungsmittel, bezogen auf seine Gesamtmenge, 10 bis 95 Vol.-% mindestens einer entaromatisierten Erdölfraktion eines Siedebereiches zwischen 150 und 260°C und eines Flammpunktes von über 45°C sowie 90 bis 5 Vol.-% mindestens eines in seinem Siedepunkt oder Siedebereich an den Siedebereich der entaromatisierten Erdölfraktion angepaßten Essigsäureesters eines gesättigten Alkohols mit mindestens 6 Kohlenstoffatomen im Alkylrest und/oder eines alkoxysubstituierten gesättigten Alkohols mit insgesamt mindestens 3 Kohlenstoffatomen im Alkoxyalkylrest und/oder mindestens eines Glykolsäure-alkyl- und/oder -alkoxyalkylesters enthält.

2. Verfahren nach Anspruch 1, dadurch gekennzeichnet, daß das organische Entwicklerlösungsmittel, bezogen auf seine Gesamtmenge, 40 bis 95 Vol.-% der entaromatisierten Erdölfraktion und 60 bis 5 Vol.-% der Essigsäure- und/oder Glykolsäureester enthält.

3. Verfahren nach Anspruch 1 oder 2, dadurch gekennzeichnet, daß das organische Entwicklerlösungsmittel, bezogen auf seine Gesamtmenge, 5 bis 20 Vol.-% der Essigsäure- und/oder Glykolsäureester enthält.

4. Verfahren nach einem der Ansprüche 1 bis 3, dadurch gekennzeichnet, daß das organische Entwicklerlösungsmittel, bezogen auf seine Gesamtmenge, 0,1 bis 30 Vol.-% mindestens eines hochsiedenden Alkohols enthält.

5. Verfahren nach Anspruch 4, dadurch gekennzeichnet, daß der Siedepunkt oder Siedebereich des Alkohols dem Siedepunkt oder dem Siedebereich der aromatisierten Erdölfraktion und/oder der Essigsäure- und/oder Glykolsäureester angepaßt ist.

6. Verfahren nach Anspruch 4 oder 5, dadurch gekennzeichnet, daß der Alkohol den gleichen Alkyl- oder Alkoxyalkylrest wie die Essigsäure-und/oder Glykolsäureester aufweist.

## Claims

1. A process for the production of a photopolymeric flexographic relief printing plate from a photosensitive recording element which contains
   A) a dimensionally stable substrate and
   B) at least one photopolymerizable recording layer having
      $b_1$) at least one elastomeric polymer as a binder,
      $b_2$) at least one photopolymerizable monomer which is compatible with the binder ($b_1$) and
      $b_3$) at least one photopolymerization initiator,

   by
   (1) imagewise exposure of the photopolymerizable recording layer (B) to actinic light and
   (2) washout (development) of the unexposed and therefore nonphotopolymerized parts of the imagewise exposed recording layer (B) with an organic developer with formation of a relief layer,

   wherein the organic developer used here contains, based on its total amount, from 10 to 95% by volume

of at least one mineral oil fraction from which aromatics have been removed and which has a boiling range of from 150 to 260°C and a flashpoint above 45°C and from 90 to 5% by volume of at least one ester of acetic acid with a saturated alcohol where the alkyl radical is of 6 or more carbon atoms and/or with an alkoxy-substituted saturated alcohol where the alkoxyalkyl radical is of 3 or more carbon atoms in total, the boiling point or boiling range of said ester being matched with the boiling range of the mineral oil fraction from which aromatics have been removed, and/or at least one alkyl and/or alkoxyalkyl glycolate.

2. A process as claimed in claim 1, wherein the organic developer contains from 40 to 95% by volume of the mineral oil fraction from which aromatics have been removed, from 60 to 5% by volume of the acetic ester and/or glycolic ester, the percentages being based on the total amount of said developer.

3. A process as claimed in claim 1 or 2, wherein the organic developer contains from 5 to 20% by volume, based on its total amount, of the acetic ester and/or glycolic ester.

4. A process as claimed in claim 1 or 2 or 3, wherein the organic developer contains from 0.1 to 30% by volume, based on its total amount, of at least one high boiling alcohol.

5. A process as claimed in claim 4, wherein the boiling point or boiling range of the alcohol is matched with the boiling point or with the boiling range of the mineral oil fraction from which aromatics have been removed and/or of the acetic ester and/or glycollic ester.

6. A process as claimed in claim 4 or 5, wherein the alcohol has the same alkyl or alkoxyalkyl radical as the acetic ester and/or glycolic ester.

## Revendications

1. Procédé de préparation d'une plaque d'impression flexographique photopolymère en relief, constituée d'un moyen d'enregistrement photosensible, qui comprend
   A) un support de dimensions stables et
   B) au moins une couche d'enregistrement photopolymérisable comprenant
      $b_1$) au moins un polymère élastomère en tant que liant,
      $b_2$) au moins un monomère photopolymérisable, qui est compatible avec le liant ($b_1$), et
      $b_3$) au moins un amorceur de photopolymérisation,

   comprenant les étapes consistant à :
   (1) exposer, de manière à former une image, la couche d'enregistrement (B) photopolymérisable à une lumière actinique et
   (2) développer la zone non exposée et donc non photopolymérisée de la couche d'enregistrement (B) exposée de manière à former une image avec un solvant de développement organique, en formant une couche en relief,

   caractérisé en ce que le solvant de développement organique utilisé ici contient, par rapport à sa quantité totale, de 10 à 95 % en volume d'au moins une fraction de pétrole débarrassée des constituants aromatiques, située dans une gamme d'ébullition comprise entre 150 et 260°C et ayant un point d'inflammation supérieur à 45°C, ainsi que de 90 à 5 % en volume d'au moins un ester de l'acide acétique, dont le point ou la gamme d'ébullition est ajusté à la gamme d'ébullition de la fraction de pétrole débarrassée des constituants aromatiques, formé avec un alcool saturé dont le reste alkyle contient au moins 6 atomes de carbone et/ou un alcool saturé à substituant alcoxy dont le reste alcoxyalkyle comprend, au total, au moins 3 atomes de carbone, et/ou au moins un ester alkylique et/ou alcoxyalkylique de l'acide glycolique.

2. Procédé selon la revendication 1, caractérisé en ce que le solvant de développement organique contient, par rapport à sa quantité totale, de 40 à 95 % en volume de la fraction de pétrole débarrassée des constituants aromatiques et de 60 à 5 % en volume de l'ester de l'acide acétique et/ou de l'acide glycolique.

3. Procédé selon l'une quelconque des revendications 1 ou 2, caractérisé en ce que le solvant de développement organique contient, par rapport à sa quantité totale, de 5 à 20 % en volume de l'ester de l'acide acétique et/ou de l'acide glycolique.

4. Procédé selon l'une quelconque des revendications 1 à 3, caractérisé en ce que le solvant de développement organique contient, par rapport à sa quantité totale, de 0,1 à 30% en volume d'au moins un alcool à point d'ébullition élevé.

5. Procédé selon la revendication 4, caractérisé en ce que le point d'ébullition ou la gamme d'ébullition de l'alcool est ajusté au point d'ébullition ou à la gamme d'ébullition de la fraction de pétrole débarrassée des constituants aromatiques et/ou de l'ester de l'acide acétique et/ou de l'acide glycolique.

6. Procédé selon la revendication 4 ou 5, caractérisé en ce que l'alcool contient le même reste alkyle ou alcoxyalkyle que l'ester de l'acide acétique et/ou de l'acide glycolique.